# FASCICULE DE BREVET EUROPEEN

(11) **EP 0 340 100 B1**
(45) Date de publication et mention de la délivrance du brevet: **29.12.1993**
(21) Numéro de dépôt: 89401173.3
(22) Date de dépôt: 25.04.1989
(51) Int. Cl.: G06K 19/06

(54) **Procédé de réalisation de cartes à mémoire et cartes obtenues par ledit procédé**
Herstellungsverfahren von Speicherkarten und Karten, die nach diesem Verfahren hergestellt sind
Manufacturing process for memory cards, and cards obtained by this process

(30) Priorité: 16.09.1988 FR 8812088; 28.04.1988 FR 8805671
(43) Date de publication de la demande: 02.11.1989
(73) Titulaire: SCHLUMBERGER INDUSTRIES, F-92120 Montrouge (FR)
(72) Inventeur: Rose, René, F-78190 Voisin le Bretonneux (FR)
(74) Mandataire: Hasenrader, Hubert

(56) Documents cités:
- EP-A- 0 277 854
- PATENT ABSTRACTS OF JAPAN vol. 10, no. 45 (P-430)(2102) 21 février 1986 & JP-A-60 189586
- PATENT ABSTRACTS OF JAPAN vol. 10, no. 80 (P-441)(2137) 29 mars 1986 & JP-A-60 217491

## Description

La présente invention concerne un procédé de réalisation de cartes à mémoire notamment électronique et des cartes obtenues par la mise en oeuvre dudit procédé.

Les cartes à mémoire comprennent essentiellement un corps de carte qui est réalisé en général en un matériau plastique et un module mémoire. Dans le cas des cartes à mémoire électronique le module mémoire est un module électronique comportant essentiellement une pastille semi-conductrice ou "chip" dans laquelle est réalisé un circuit intégré et un élément de circuit imprimé sur lequel est fixé le chip ou autre et qui définit des plages externes de contact électrique. Le module électronique est fixé dans le corps de la carte de telle manière que les plages de contact électrique affleurent une des faces principales du corps de carte.

Le corps de carte a la forme d'un parallèlèpipède rectangle dont l'épaisseur doit être inférieure à 1 mm et qui est définie par la norme ISO 7810. Les bords du corps de carte servent de référence pour le positionnement de la carte dans le lecteur de cartes de telle manière que les plages de contact de la carte viennent en contact électrique avec le connecteur du lecteur de cartes.

Il faut ajouter que le corps de carte doit en outre répondre à d'autres spécifications concernant la qualité de l'état de surface et les propriétés de tenue en flexion bien précises aussi bien selon la direction longitudinale du corps de carte que selon sa direction transversale et en torsion. Ces spécifications sont définies par la norme ISO (mentionnée ci-dessus). De plus il faut que le corps de carte ne favorise pas le stockage de charges électrostatiques.

Pour résoudre ce problème on a déjà proposé dans la demande de brevet français FR-A-2 609 821 publiée le 22 juillet 1988 de fabriquer la carte par un procédé de moulage par injection qui comprend les étapes suivantes :
On fournit un module mémoire présentant une face d'accès et au moins un élément d'ancrage,
On place ledit module dans un moule et on le maintient en place de telle manière que la face d'accès du module mémoire soit disposée contre une paroi du moule,
On introduit dans le moule un matériau plastique de telle manière que le matériau plastique occupe la totalité de l'espace limité par les parois du moule non occupé par ledit module mémoire, et
On démoule la pièce ainsi réalisée.

Un autre problème que pose la fabrication de cartes à mémoire est la réalisation des éléments graphiques que comporte en général au moins une des faces principales du corps de carte, ces éléments graphiques pouvant être des informations alphanumériques ou des dessins à but décoratif.

Lorsque l'élément graphique présente une certaine complexité soit par la forme du tracé soit par la nature des nuances de couleur à obtenir, l'étape d'impression du graphisme, par sérigraphie ou par offset, peut conduire à un échec surtout si l'on se montre très exigeant sur la qualité du graphisme et des couleurs. En cas d'échec, il faut se résoudre à mettre au rebut les cartes dont la qualité du graphisme est jugée insuffisante. Cela signifie que les coûts en matière, en composants et en usinage des étapes de fabrication de la carte précédant l'étape de réalisation du graphisme sont perdus. Ces coûts sont particulièrement élevés si la réalisation du graphisme intervient lorsqu'un module électronique a déjà été implanté dans le corps de la carte. Cette situation se présente notamment, mais non exclusivement, lorsque la carte est fabriquée en moulant le corps de la carte directement sur le module électronique selon la technique décrite dans la demande de brevet français FR-A-2 609 821 déjà citée.

Le document JP-A-60 189586 décrit un procédé de réalisation de cartes à mémoire électronique d'un type non précisé dans lequel des modules électroniques sont fixés sur une feuille support. La portion de la feuille comportant un module électronique est introduite dans un moule par transfert et après l'opération de moulage la feuille est découpée aux dimensions du corps de carte.

Pour remédier à ces inconvénients un objet de l'invention est de fournir un procédé de réalisation de carte, notamment de carte à mémoire, dans lequel l'étape de réalisation du graphisme sur le corps de carte ne peut en elle-même entraîner le rejet de la carte.

Un objet de l'invention est de fournir un mode de réalisation d'une carte à mémoire, notamment électronique, par surmoulage du corps de carte sur le module mémoire, qui permette de plus, si on le souhaite, de réaliser les éléments graphiques dans des conditions économiques particulièrement intéressantes.

Pour atteindre ce but, selon l'invention, le procédé de réalisation d'une carte à mémoire du type ISO comprenant un corps de carte dont l'épaisseur est inférieure à 1 mm présentant deux faces principales parallèles entre elles et un module mémoire présentant une face d'accès disposée dans la première desdites faces principales du corps de carte qui se caractérise en ce qu'il comprend les étapes suivantes :
On fournit un moule d'injection dont l'empreinte définit la forme extérieure de ladite carte,
On fournit un élément support,
On fournit un module mémoire présentant une face d'accès,
On fixe ledit module mémoire, par sa face d'accès, sur une face de l'élément support,
On place ledit élément support dans ledit moule de telle façon que sa périphérie soit solidaire dudit moule,
On injecte dans ledit moule un matériau plastique pour que celui-ci remplisse ladite empreinte du moule et que ledit module soit entouré par ledit matériau,
On démoule la pièce ainsi obtenue et on sépare l'élément support de ladite pièce, par quoi ledit module est inséré dans ledit corps, et
Après démoulage, on obtient une carte à mémoire présentant un corps de carte ayant sa forme définitive et dans lequel le module électronique est déjà implanté.

Selon un mode préféré de mise en oeuvre du procédé permettant de réaliser simultanément des éléments graphiques sur la première face principale du corps de carte, l'élément support présente, sur la face sur laquelle est fixé le module mémoire, des éléments d'impression, et lors de l'injection du matériau plastique dans le moule lesdits éléments d'impression adhèrent à la face du volume de matériau injecté en contact avec l'élément support, par quoi on obtient une carte à mémoire comportant de plus des éléments graphiques sur la première face principale du corps de carte.

De toutes façons l'invention sera mieux comprise à la lecture de la description qui suit de plusieurs modes de réalisation de l'invention donnés à titre d'exemples non limitatifs. La description se réfère au dessin annexé sur lequel :
La figure 1 est une vue en coupe d'un élément support d'impression utilisable dans ladite invention,
La figure 2 est une vue en coupe de l'élément support muni de modules électroniques,
La figure 3 est une vue en coupe verticale d'un premier type de moule pour réaliser une carte à mémoire électronique,
La figure 4 est une vue de dessus d'une carte à mémoire électronique, et
La figure 5 est une vue en coupe verticale d'un deuxième type de moule pour réaliser une carte à mémoire électronique.

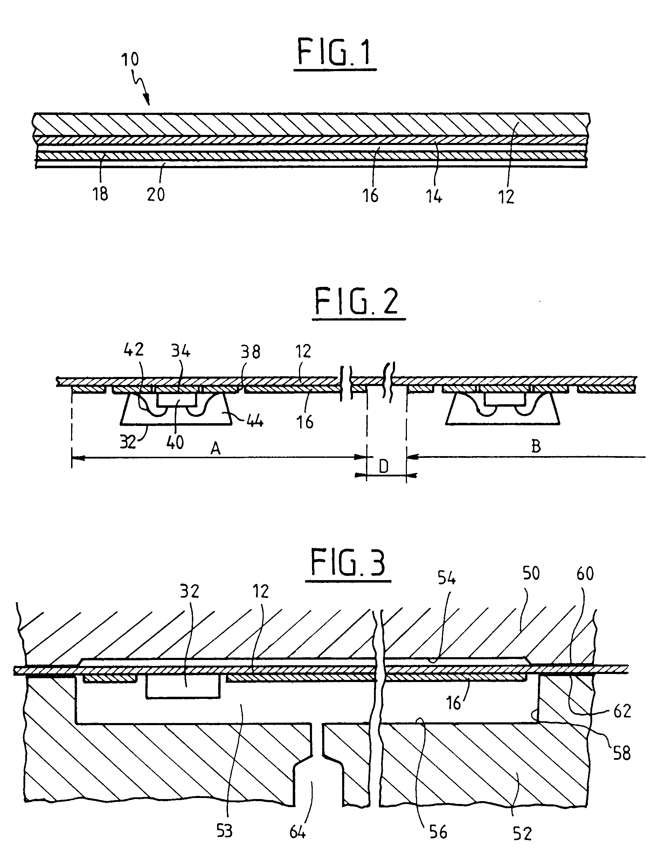

Avant d'expliquer plus en détails l'ensemble de l'invention, on va décrire, en se référant à la figure 1, un élément support utilisable, permettant de plus de réaliser les graphismes souhaités.

L'élément support, portant la référence 10, comporte un support en un matériau plastique. Le support 12 est de préférence en polyester et a une épaisseur de l'ordre de 25 micromètres. Sur ce support 12 qui joue le rôle de support mécanique sont réalisés les éléments d'impression servant ultérieurement à obtenir le graphisme souhaité. Pour chaque élément d'impression, on trouve une couche de détachement 14, une couche de décoration 16 constituée par des pigments, éventuellement une couche de vernis 18, et une couche d'adhésif 20 dont l'épaisseur est de l'ordre de 1 à 2 micromètres.

Sur une même feuille support 12 on peut réaliser un grand nombre de motifs identiques. Un tel produit est proposé notamment par la Société allemande Léonard Kurz Gmbh.

En se référant maintenant aux figures 2 et 3 on va décrire un premier mode de réalisation de cartes à mémoire électronique selon l'invention.

On part d'un élément support 10 qui comporte une pluralité de motifs identiques, chaque motif correspondant à l'ensemble du graphisme qui doit être réalisé sur une des faces du corps de la carte. Sur la figure 2 on a représenté les motifs A et B. Chaque motif est séparé des motifs voisins par un espace vierge dont l'utilité sera explicitée ultérieurement.

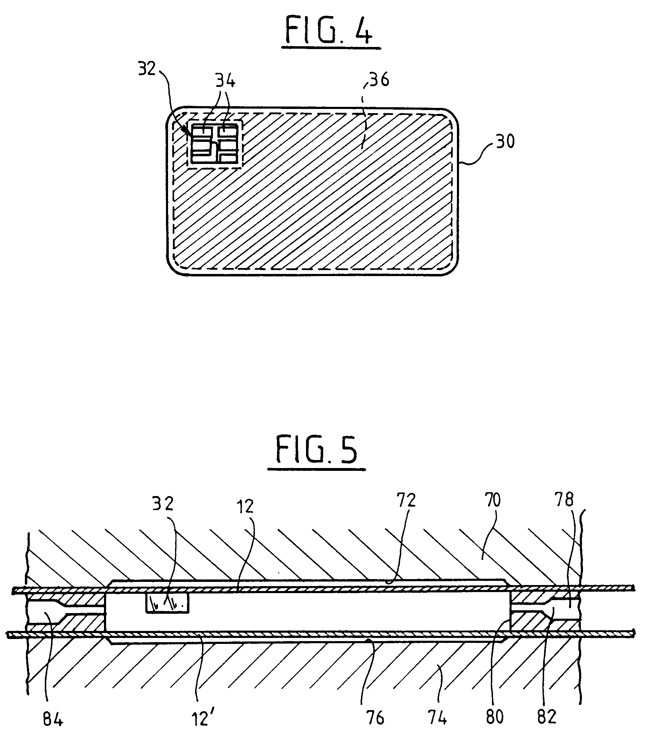

La figure 4 montre un corps de carte 30 réalisé selon l'invention. Dans la face principale visible du corps de carte on a représenté le module électronique 32 dont seules les plages externes de contact électrique 34 sont visibles. On a également représenté en 36 les zones du corps de carte qui comportent un graphisme. La zone 36 laisse dégagée la portion de la face du corps de carte 30 occupée par les plages externes 34 de contact électrique.

Si l'on revient à la figure 2, on voit que, pour chaque motif, la zone où des graphismes 36 sont réalisés laisse à nu la partie 38 du support plastique 12 où doit se trouver le module électronique 32, lorsque la carte est terminée.

La module électronique 32 comprend un lead frame ou un élément de circuit imprimé sur lequel sont réalisées les plages externes 34, une pastille semi conductrice 40 fixée sur le circuit imprimé ou le lead frame, des fils conducteurs 42 qui relient les bornes de la pastille 40 aux plages de contact 34 et un matériau d'enrobage 44 qui entoure la pastille 40 et les fils 42. Un module 32 est collé sur le support 12 à chaque emplacement 38, de telle manière que chaque motif comporte un module.

Comme le montre la figure 2, la face externe des plages externes de contact est directement collée sur le support 12.

On obtient ainsi une bande formée par le support 12 qui comporte sur une de ses faces une pluralité de motifs (A, B..) chaque motif comportant de plus un module électronique 32.

Dans l'étape suivante on réalise le corps de la carte par moulage par injection d'un matériau plastique qui est de préférence de l'ABS (acrylo-butadière styrène). La figure 3 montre le moule utilisé. Il comprend une partie fixe 50 et une partie mobile 52. Ces deux parties définissent une empreinte 53 qui donne la forme externe du corps de carte. La partie fixe 50 définit par sa paroi interne 54 une des faces principales du corps de carte. La partie mobile 52 définit par sa paroi interne 56 la deuxième face principale du corps de carte et par sa paroi interne 58 la tranche du corps de carte. Les parties fixe 50 et mobile 52 comportent chacune une portée 60 et 62, ces deux portées étant normalement en contact mutuel lorsque le moule est fermé.

Le moule étant ouvert, la bande formée par le support 12 est placée entre la partie fixe 50 et la partie mobile 52 du moule. La bande est positionnée par rapport à l'empreinte 53 de telle manière que le graphisme 16 portée par le support 12, et, par voie de conséquence, le module électronique 32 soient parfaitement positionnés par rapport à la paroi latérale 58 de l'empreinte, c'est-à-dire par rapport à la tranche du corps de carte qui va être réalisé. Puis le moule est fermé. Le support 12 est pincé entre les portées 60 et 62 des deux parties du moule dans la zone D du support 12 qui entoure un motif. Puis on procède à l'injection du matériau plastique dans l'empreinte 53 par la buse d'injection 64, l'ABS est injecté de préférence à une température comprise entre 220°C et 280°C.. De préfèrence la buse 64 est disposée au centre de la paroi 56 de la partie mobile 52. Le matériau plastique remplit l'empreinte 53 en plaquant le support 12 contre la paroi interne 54 du moule. Le matériau plastique entoure le module électronique 32, à l'exception de sa face collée sur le support 12 et il est au contact du graphisme 16. Sous l'effet de la pression et de la température, les éléments décoratifs 16 se fixent sur la face correspondante du volume de matériau plastique en tendant à se séparer du support 12. Ce résultat est obtenu par l'activation de la couche d'adhésif 20 et de la couche de décollement 14.

Si le module électronique 32 a une épaisseur suffisamment réduite par rapport à l'épaisseur de la carte, il est possible de prévoir que la buse d'injection débouche 64 dans la face 56 du moule, en regard du module électronique. On peut également prévoir plusieurs buses d'injection. Egalement il est possible de disposer des buses d'injection dans la face latérale 58 de l'empreinte du moule. De préfèrence alors les buses sont disposées à certains "coins" de l'empreinte du moule.

Après avoir ouvert le moule on démoule le corps de carte dans lequel est inserré le module électronique 32 et qui comporte le graphisme 36 désiré sur sa face principale.

On comprend que le support 12 joue un double rôle, il permet la réalisation du graphisme, et il assure le positionnement précis du module électronique par rapport à l'empreinte du moule et donc par rapport au corps de carte. De plus les plages externes du module étant collées sur le support 12, elles sont protégées contre une éventuelle remontée du matériau d'injection qui pourrait tendre à les recouvrir.

Le support 12 qui ne porte plus ni module électronique ni les graphismes reste dans le moule après l'enlèvement de la carte.

La figure 5 montre une variante de moule utilisable pour réaliser une carte à mémoire électronique présentant des éléments graphiques sur ses deux faces principales. Le moule est constitué en trois parties. Une première partie 70, mobile, comporte la partie 72 de l'empreinte du moule qui définit la première face principale du corps de carte.

Une deuxième partie 74, mobile, comporte la partie 76 de l'empreinte du moule qui définit la deuxième face principale du corps de carte. Une troisième partie 78, fixe, qui est enserrée entre les parties 70 et 74 du moule lorsque celui-ci est fermé, comporte la partie 80 de l'empreinte qui définit le bord ou la tranche du corps de carte. La partie 78 du moule comporte, par exemple, deux buses d'injection 82 et 84.

La fabrication d'une carte à l'aide du moule de la figure 5 est réalisée de la manière suivante : le moule est ouvert, c'est-à-dire que les parties 70 et 74 sont écartées de la partie fixe 78. Un film 12 support d'éléments d'impression muni de son module électronique 32 est placé entre les parties 70 et 78 du moule comme cela a déjà été décrit en liaison avec la figure 3.

Un deuxième film 12′ support d'éléments d'impression, mais dépourvu de module électronique, est placé de la même manière entre les parties 78 et 74 du moule. Puis on ferme le moule à l'aide de moyens de verrouillage non représentés sur la figure 4. Ainsi les films support 12 et 12' sont solidaires du moule puisqu'ils sont pincés entre les trois parties 70, 74 et 78 du moule. On procède ensuite à l'injection du matériau plastique dans le moule par les buses 82 et 84, et on démoule la carte ainsi obtenue.

Dans la description précédente on a considéré le cas où un graphisme devait en outre être réalisé sur au moins une des faces principales du corps de la carte. Il va de soi que le but premier de l'invention est de fabriquer une carte à mémoire sans graphisme. Dans ce cas le film support a pour seule fonction d'assurer le positionnement et le maintien du module dans le moule. Il est donc dépourvu d'éléments d'impression. Le film support doit être réalisé en un matériau qui n'adhère pas au matériau d'injection à sa température d'injection c'est-à-dire à une température de l'ordre de 200 à 280°C. En ce qui concerne le matériau adhésif qui sert à fixer le module électronique sur le film support, il doit présenter certaines caractéristiques. Il doit conserver ses propriétés adhésives durant la phase de remplissage du moule. De préférence il perd, par effet thermique, ses propriétés adhésives lors de la phase de refroidissement du matériau de moulage. Ainsi lors du démoulage de la carte celle-ci est aisément séparée du film support. Eventuellement on procède au nettoyage chimique des plages de contact externe pour faire disparaître les traces résiduelles de matériau adhésif.

## Revendications

1. Procédé de réalisation d'une carte à mémoire comprenant un corps de carte présentant deux faces principales parallèles entre elles et un module mémoire (3) comportant une face d'accès disposée dans la première desdites faces principales du corps de carte, procédé qui comprend les étapes suivantes :
on fournit un moule (50,52) dont l'empreinte définit la forme extérieure de ladite carte,
on fournit un élément support (12),
on fournit un module mémoire (32) présentant une face d'accès,
on fixe ledit module mémoire sur une face de l'élément support,
on place ledit élément support dans ledit moule de telle façon que sa périphérie soit solidaire dudit moule,
on introduit dans ledit moule un matériau plastique pour que celui-ci remplisse ladite empreinte du moule et que ledit module mémoire soit entouré par le matériau plastique, et
on démoule la pièce ainsi obtenue, par quoi ledit module mémoire est inséré dans le corps de la carte, ladite face d'accès étant disposée dans la première face principale du corps de la carte,
le procédé se caractérisant en ce que l'épaisseur dudit corps de carte est inférieure à 1 mm, et en ce que :
on fixe ledit module sur l'élément support par sa face d'accès,
on injecte sous pression ledit matériau plastique, et
lors du démoulage, on sépare l'élément support de la pièce obtenue par moulage.

2. Procédé selon la revendication 1, caractérisé en ce que l'élément support (12) comporte de plus, sur sa face où est fixé le module mémoire (32), des éléments d'impression (16) et en ce que, lors de l'injection du matériau plastique dans le moule, lesdits éléments d'impression adhèrent à la face du volume de matériau plastique injecté en contact avec ledit élément support, par quoi on obtient une carte à mémoire comportant de plus des éléments graphiques sur la première face principale de corps de carte.

3. Procédé selon l'une quelconque des revendications 1 et 2, caractérisé en ce que ledit module mémoire est un module électronique dont la face d'accès comporte des plages externes de contact électrique.

4. Procédé selon la revendication 2, caractérisé en ce que les éléments d'impression comprennent des éléments de graphisme fixés sur ledit support par une couche de détachement, la face des éléments de graphisme non tournée vers ledit support étant recouverte d'un matériau adhésif activable à chaud.

5. Procédé selon l'une quelconque des revendications 1 à 4, caractérisé en ce que le matériau plastique est de l'ABS.

## Claims

1. Manufacturing process for a memory card comprising a card body having two main faces parallel to one another and a storage module (3) comprising an access face disposed in the first of the said main faces of the card body, this process comprising the following steps:
- a mould (50, 52) the cavity of which defines the outer shape of the said card is provided;
- a support element (12) is provided;
- a storage module (32) having an access face is provided;
- the said storage module is fixed to one face of the support element;
- the said support element is placed in the said mould in such a manner that its periphery is fixed to the said mould,
- a plastic material is introduced into the said mould so that it fills the said cavity of the mould and the said storage module is surrounded by the plastic material, and
- the component obtained in this manner is removed from the mould, whereby the said storage module is inserted into the body of the card, the said access face being disposed in the first main face of the body of the card,
the process being characterised in that the thickness of the said card body is less than 1 mm and that:
- the said module is fixed to the support element via its access face;
- the said plastic material is injected under pressure, and
- at the time of removal from the mould, the support element is separated from the component obtained by moulding.

2. Process according to claim 1, characterised in that the support element (12) additionally comprises, on its face to which the storage module (32) is fixed, printing elements (16), and that when the plastic material is injected into the mould, the said printing elements adhere to the face of the volume of injected plastic material in contact with the said support element, whereby a memory card in addition comprising graphic elements on the first main face of the card body is obtained.

3. Process according to either of claims 1 and 2, characterised in that the said storage module is an electronic module the access face of which comprises external electrical contact tabs.

4. Process according to claim 2, characterised in that the printing elements comprise graphic elements fixed to the said support by a separating layer, the face of the graphic elements not directed towards the said support being covered with an adhesive material activated by heat.

5. Process according to any one of claims 1 to 4, characterised in that the plastic material is ABS.

## Patentansprüche

1. Verfahren zur Herstellung einer Speicherkarte mit einem Kartenkörper mit zwei zueinander parallelen Hauptseiten und einem elektronischen Speichermodul (3), das eine in der ersten der Hauptseiten des Kartenkörpers angeordnete Zugangsseite hat, welches Verfahren folgende Schritte umfaßt:
Bereitstellen einer Form (50, 52), deren Vertiefung die äußere Form der Karte definiert,
Bereitstellen eines Trägerelements (12),
Bereitstellen eines Speichermoduls (32) mit einer Zugangsseite,
Befestigen des Speichermoduls auf einer Seite des Trägerelements,
Plazieren des Trägerelements in der Form, so daß sein Rand mit der Form fest verbunden ist,
Einführen eines Plastikmaterials in die Form, damit dieses die Vertiefung der Form ausfüllt und das Speichermodul umgibt, und
Lösen des so erhaltenen Teils aus der Form, wodurch das Speichermodul in den Kartenkörper eingefügt ist und die Zugangsseite auf der ersten Hauptseite des Kartenkörpers angeordnet ist,
welches Verfahren
**dadurch gekennzeichnet**
ist, daß die Dicke des Kartenkörpers kleiner als 1 mm ist und daß:
das Modul auf dem Trägerelement über seine Zugangsseite befestigt wird,
das Plastikmaterial unter Druck eingespritzt wird und
beim Lösen aus der Form das durch Formen erhaltene Teil vom Trägerelement getrennt wird.

2. Verfahren nach Anspruch 1,
dadurch gekennzeichnet,
daß das Trägerelement (12) auf der Seite, auf der das Speichermodul (32) befestigt ist, Druckelemente (16) aufweist, und daß beim Einspritzen des Plastikmaterials in die Form die Druckelemente an der das Trägerelement berührenden Seite des Plastikvolumens haften, wodurch eine Speicherkarte erhalten wird, die zusätzlich graphische Elemente auf der ersten Hauptseite des Kartenkörpers aufweist.

3. Verfahren nach einem der Ansprüche 1 und 2,
dadurch gekennzeichnet,
daß das Speichermodul ein elektronisches Modul ist, dessen Zugangsseite äußere elektrische Kontaktflächen aufweist.

4. Verfahren nach Anspruch 2,
dadurch gekennzeichnet,
daß die Druckelemente auf dem Träger durch eine Trennschicht befestigte Graphikelemente umfassen, deren nicht zum Träger hin gewandte Seite von einem hitzeaktivierbaren Klebmittel bedeckt ist.

5. Verfahren nach einem der Ansprüche 1 bis 4,
dadurch gekennzeichnet,
daß das Plastikmaterial ABS ist.
